# EUROPÄISCHE PATENTSCHRIFT

(11) **EP 0 368 045 B1**
(45) Veröffentlichungstag und Bekanntmachung des Hinweises auf die Patenterteilung: **25.01.1995**
(21) Anmeldenummer: 89119367.4
(22) Anmeldetag: 18.10.1989
(51) Int. Cl.: H05K 7/20

(54) **Baugruppenträger für Leiterplatten mit elektronischen Bauelementen**
Rack for printed-circuit boards with electronic components
Rack pour circuits imprimés à composants électroniques

(30) Priorität: 07.11.1988 DE 3837744
(43) Veröffentlichungstag der Anmeldung: 16.05.1990
(73) Patentinhaber: Knürr Mechanik für die Elektronik AG, D-81829 München (DE)
(72) Erfinder: Paggen, Wolfgang, D-8130 Starnberg (DE); Neblich, Josef, D-8059 Wartenberg (DE)
(74) Vertreter: Weber, Otto Ernst, Dipl.-Phys.

(56) Entgegenhaltungen:
- EP-A- 0 236 501
- US-A- 4 758 925
- IBM TECHNICAL DISCLOSURE BULLETIN. vol. 20, no. 6, November 1977, NEW YORK US,Seiten 2428 - 2429; GAUNT AND HILLARY: "Cooling electrical equipment"

## Beschreibung

Die Erfindung betrifft einen Baugruppenträger mit einem Aufnahmeraum für eine Vielzahl von vertikal angeordneten, elektronische Bauelemente tragenden Leiterplatten gemäß dem Oberbegriff des Anspruchs 1.

Derartige Baugruppenträger werden bekanntlich in großem Umfang beim modularen Aufbau von elektronischen Geräten und Anlagen eingesetzt. Sie dienen einerseits der mechanischen Aufnahme und andererseits der elektrischen Verbindung von Baugruppen und Leiterplatten, die maßlich durch vorgegebene Raster und Teilungsschritte aufeinander abgestimmt sind. Ein standardisiertes Format ist hierbei das 19-Zoll-Aufbausystem.

Die von den elektronischen Bauelementen auf den Leiterplatten erzeugte Verlustwärme muß durch Kühlung abgeführt werden. Hierzu erfolgt mittels einer Lüfteranordnung eine Durchzugsbelüftung der Leiterplatten, indem kühle Außenluft angesaugt wird und die erwärmte Luft wieder nach außen abgegeben wird.

Bei geschlossenen Anordnungen erfolgt sinngemäß eine Zwangsumwälzung durch Innenlüfter.

Häufig werden die Lüfter in der Rückwand des Baugruppenträgers angeordnet und es wird Kühlluft über Öffnungen in der Frontseite des Baugruppenträgers eingesaugt. Aus dem DE-GM 87 13766 ist ein derartiger Baugruppenträger bekannt, bei welchem unterhalb des Baugruppen-Aufnahmeraums ein Verteilerraum angeordnet ist, der mit einer frontseitigen Öffnung in Verbindung steht. Oberhalb des Aufnahmeraums befindet sich ein Luftsammelraum, aus welchem die erwärmte Luft nach hinten über einen Axiallüfter abgesaugt und ausgeblasen wird. Die Höhe des Verteilerraums und des Sammelraums entspricht hierbei jeweils einer halben Höheneinheit, während der Aufnahmeraum bzw. die dort eingesteckten Leiterplatten zwei Höheneinheiten des 19-Zoll-Systems aufweisen. Insbesondere wenn die Leiterplatten dicht nebeneinander angeordnet sind und somit die Zwischenräume klein sind, führt eine unterschiedliche Bestückung der einzelnen Leiterplatten mit mehr oder weniger großen Bauelementen dazu, daß einerseits als Drosseln wirkende Verengungen und andererseits relativ große Öffnungen in der Querschnittsfläche des Aufnahmeraums entstehen. Wenn der Verteiler wie im bekannten Beispiel relativ zum Volumen des Aufnahmeraums zu klein gewählt ist, hat die angesaugte Kühlluft das Bestreben, bevorzugt durch diejenigen Zwischenräume zu strömen, die einen weiten offenen Querschnitt haben, während der Luftstrom in den verengten Zwischenräumen relativ klein ist. Dies führt dazu, daß gerade die am dichtesten bestückten Leiterplatten, an welchen die meiste Verlustwärme erzeugt wird, unterbelüftet sein können.

Aus der US-A 4,758,925 ist ein Baugruppenträger bekannt, welcher für eine horizontale Aneinanderreihung vorgesehen ist. Angrenzend an einen Aufnahmeraum für Leiterplatten ist ein Luftraum mit einem diagonal verlaufenden Luftleitblech angeordnet, welches den Luftraum in einen Luftverteiler und Luftsammler teilt. Der Luftsammler geht in einen Verbindungsgang über, durch den der durch den Aufnahmeraum geleitete Luftstrom mit Hilfe einer ersten Gebläseanordnung, die in der Rückwand des Baugruppenträgers installiert ist, ausgeführt wird. Einer gleichmäßigen Belüftung der im Aufnahmeraum angeordneten Baugruppen und Leiterplatten steht eine Doppelgebläseanordnung an der Lufteintrittsöffnung des Aufnahmeraums entgegen. Die Doppelgebläseanordnung saugt Luft aus einem Zwischenraum, der zwischen dem Aufnahmeraum und der Gehäuseöffnung des Baugruppenträgers angeordnet ist und in einen relativ großen Hohlraum hinter dem Aufnahmeraum übergeht, an.

Der Erfindung liegt die **Aufgabe** zugrunde, einen Baugruppenträger zu schaffen, der einen besonders gleichmäßigen Luftdurchsatz zwischen den Leiterplatten gewährleistet.

Diese Aufgabe wird bei einem Baugruppenträger der gattungsgemäßen Art durch die kennzeichnenden Merkmale des Anspruchs 1 gelöst.

Zweckmäßige und vorteilhafte Ausgestaltungen sind in den Unteransprüchen sowie in der Figurenbeschreibung aufgenommen.

Erfindungsgemäß wird eine verbesserte Zwangslüftung durch eine Baugruppenträger-Konstruktion erreicht, bei welcher ein Aufnahmeraum derart angeordnet ist, daß dessen Lufteintrittsöffnung der Gehäuseöffnung des Baugruppenträgers entspricht.

Die Lufteintrittsöffnung eines Aufnahmeraums ist somit unmittelbar in einem Gehäuseboden des Baugruppenträgers und deckungsgleich zur Gehäuseöffnung des Baugruppenträgers angeordnet.

Bei einer Stapelanordnung mehrerer Baugruppenträger decken sich die oberseitige Gehäuseöffnung des jeweils unteren Baugruppenträgers und die Lufteintrittsöffnung des Aufnahmeraums eines oberen Baugruppenträgers. Indem ein oberhalb des Aufnahmeraums angeordneter Luftraum mit einer frontseitigen Luftansaugöffnung durch ein diagonal verlaufendes Luftleitblech in einen Luftverteiler und einen Luftsammler geteilt ist und der Luftsammler mit einem zweiten, von der Oberseite des Baugruppenträgers bis zu einer Höhe unterhalb der Oberseite des Aufnahnmeraums und von einer rückseitigen Abdeckplatte und von einer rückseitigen Abdeckplatte des Aufnahmeraumes bis zu einer Rückwand sich erstreckenden Luftraum verbunden ist, besteht die Möglichkeit, mit einer Gebläseanordnung in der Rückwand des zweiten Luftraums bzw. des Baugruppenträgers eine besonders gleichmäßige Luftströmung im Aufnahmeraum zu erreichen.

Besonders vorteilhaft ist es, daß der zweite Luftraum über eine innenseitige Verbindungsöffnung mit dem ersten, den Luftsammler und Luftverteiler aufweisenden Luftraum in Verbindung steht, wobei der Luftverteiler die gesamte frontseitige Luftansaugöffnung zwischen dem oberen Rand des Aufnahmeraums und des Baugruppenträgers sowie eine sich im wesentlichen über die gesamte horizontale Querschnittsfläche des Aufnahmeraums erstreckende deckenseitige Öffnung des Baugruppenträgers umfaßt und dem Luftsammler die gesamte oberseitige horizontale Luftaustrittsöffnung des Aufnahmeraums sowie die zwischen dem oberen Rand des Aufnahmeraums und des Baugruppenträgers sich erstreckende vertikale, innenseitige Verbindungsöffnung zur Gebläseanordnung zugeordnet sind.

Die Erfindung hat den Vorteil, daß der wirksame Querschnitt des Luftverteilers und des Luftsammlers im Verhältnis zu dem zur Verfügung stehenden Ansaug- und Absaugraum optimiert wird. Es ist vorteilhaft daß der in einem Baugruppenträger jeweils angeordnete Verteiler nicht für den betreffenden Baugruppenträger selbst, sondern für einen auf diesem Baugruppenträger gestapelten weiteren Baugruppenträger vorgesehen ist. Durch diese Verteilung, die ihre Wirkung bei modularer, gestapelter Anordnung mehrerer Baugruppenträger entfaltet, kann der zur Verfügung stehende Raum ohne Querchnittsverlust ausgenützt werden. Das Volumen des Luftverteilers bzw.-Sammlers kann dabei so groß gewählt werden, daß durch die Drosselwirkung der Leiterplatten ein Rückstau erzeugt wird, der das Bestreben hat, sich unter gleichmäßiger Druckverteilung über die einzelnen Platten-Zwischenräume abzubauen. Somit wird eine gleichmäßige Zwangskühlung aller Bauelemente erreicht.

Eine bevorzugte Weiterbildung der Erfindung besteht darin, daß die Höhe des Luftraums mit Luftverteiler und Luftsammler eine Höheneinheit gemäß dem 19-Zoll-System aufweist. Der dabei zur Verfügung stehende Querschnitt ist ausreichend, einen dicht mit Leiterplatten bestückten Aufnahmeraum von sechs Höheneinheiten gemäß dem 19-Zoll-System zuverlässig zu belüften.

Eine weitere bevorzugte Ausgestaltung der Erfindung besteht darin, daß das diagonal angeordnete Luftleitblech an der Deckenseite des Baugruppenträgers bis zur Rückwand des Baugruppenträgers verlängert ist. Das hat den Vorteil, daß die Zwangsbelüftung des Aufnahmeraums bzw. die Luftabsaugung auch dann sichergestellt ist, wenn der Baugruppenträger sich nicht im Stapelverbund mit anderen Baugruppenträgern.befindet. Das bis an die Wand geführte Luftleitblech dichtet den Baugruppenträger zwischen dem Luftsammler und dem Lüfter gegen Fremdluft ab.

Im Stapelverbund kann diese Abdichtung bevorzugt durch ein Bodenblech des Baugruppenträgers erfolgen, welches sich vom Aufnahmeraum bis zur Rückseite erstreckt.

Grundsätzlich ist ein Luftleitblech oder ein Bodenblech besonders gut geeignet. Selbstverständlich kann jedoch anstelle von metallischen Materialien ein anderes dichtend abschließendes, biegesteifes Material, wie beispielsweise Kunststoff gewählt werden.

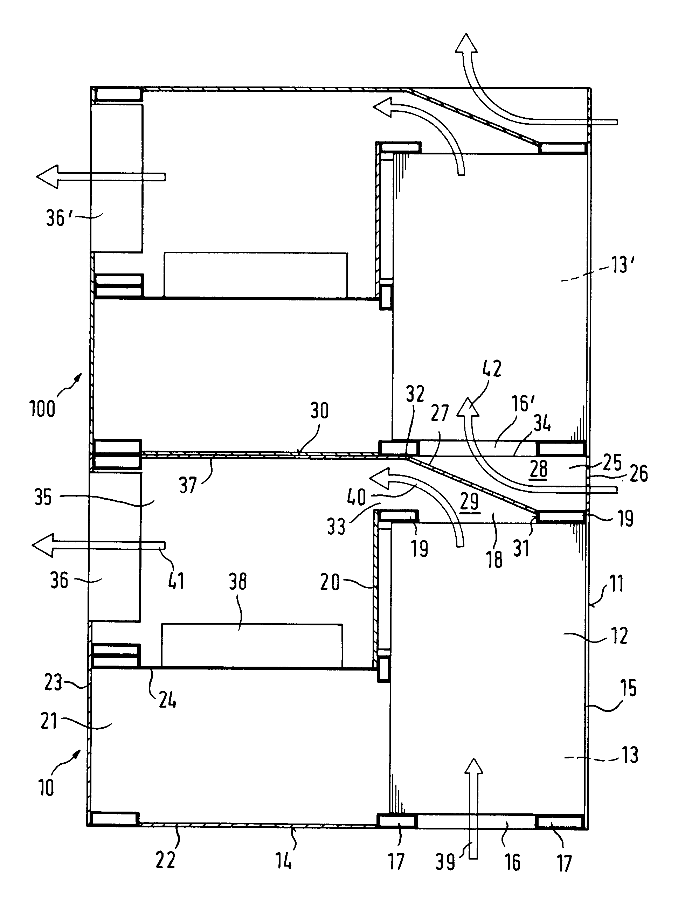

Nachfolgend wird die Erfindung anhand eines in der Zeichnung dargestellten Ausführungsbeispiels weiter beschrieben.

Die einzige Figur zeigt schematisch einen Vertikal-Querschnitt durch zwei aufeinander gestapelte Baugruppenträger.

In der Figur ist mit 10 ein unterer Baugruppenträger und mit 100 ein auf dem unteren Baugruppenträger 10 aufgesetzter, gleichartiger oberer Baugruppenträger bezeichnet. Da die konstruktiven Einzelheiten des oberen und des unteren Baugruppenträgers 10,100 gleich sind, beschränkt sich die nachfolgende Beschreibung auf den unteren Baugruppenträger 10. Sinngemäß ist sie auch auf den oberen Baugruppenträger 100 übertragbar.

Es handelt sich beim Baugruppenträger 10 um eine modulare Einheit gemäß dem 19-Zoll-System. Er weist in dem dargestellten Beispiel sieben Höheneinheiten des 19-Zoll-Systems auf. Von der rechts dargestellten Frontseite 11 des Baugruppenträgers 10 her sind in vertikaler Anordnung Steckkarten 12 eingesteckt, welche mit elektronischen Bauelementen (nicht dargestellt) bestückt sind. Die Steckkarten 12 weisen jeweils sechs Höheneinheiten des 19-Zoll-Systems auf. Sie befinden sich in einem Aufnahmeraum 13, der sich von der Unterseite 14 des Baugruppenträgers 10 entsprechend um sechs Höheneinheiten erstreckt, so daß zwischen der Oberseite des Aufnahmeraums 13 und der Oberseite des Baugruppenträgers 10 ein Zwischenraum von einer Höheneinheit verbleibt, dessen Funktion nachfolgend im einzelnen beschrieben wird.

Jede der Steckkarten 12 ist mit einer senkrecht zur Zeichenebene verlaufenden Frontplatte 15 versehen, die jeweils so breit ist, daß bei vollständiger Bestückung des Aufnahmeraumes 13 über sechs Höheneinheiten eine geschlossene Frontseite gebildet wird. Die Unterseite des Aufnahmeraums 13 ist mit einer Lufteintrittsöffnung 16 versehen, die sich im wesentlichen zwischen unteren Befestigungsschienen 17 für die Steckkarten 12 über die gesamte Breite und Tiefe des Aufnahmeraums im Gehäuseboden 14 erstreckt. Eine im wesentlichen gleichartige Luftaustrittsöffnung 18 befindet sich genau gegenüber der Lufteintrittsöffnung 16 an der Oberseite des Aufnahmeraums 13 zwischen oberseitigen Befestigungsschienen 19. Die Tiefe des Aufnahmeraums 13 ist durch die Breite der Steckkarten 12 vorgegeben. Nach hinten ist der Aufnahmeraum 13 gegen den übrigen Innenraum des Baugruppenträgers 10 mit einer Abdeckplatte 20 luftdicht abgetrennt. In dem dargestellten Beispiel erstreckt sich die Abdeckplatte 20 über die oberen drei Höheneinheiten des Aufnahmeraums. Die unteren drei Höheneinheiten stehen mit einem im übrigen luftdicht abgeschlossenen Hohlraum 21 des Baugruppenträgers 10 in Verbindung.

Der Hohlraum 21 ist nach unten durch ein in den Baugruppenträger 10 eingelegtes Bodenblech 22, nach hinten durch eine Rückwand 23 und nach oben durch einen Zwischenboden 24 begrenzt.

Insgesamt wird auf diese Weise eine Konvektion zwischen der Lufteintrittsöffnung 16 und der Luftaustrittsöffnung 18 durch die Zwischenräume der Steckkarten 12 hindurch erreicht.

Ein Luftraum 25 oberhalb des Aufnahmeraums 13 ist frontseitig mit einem Lüftungsgitter 26 versehen, welches sich über die gesamte Breite des Baugruppenträgers 10 senkrecht zur Zeichenebene erstreckt. Das Lüftungsgitter 26 ist beispielsweise als perforierte Frontplatte ausgebildet.

Ferner ist der Luftraum 25 durch ein Luftleitblech 27 luftdicht in einen Luftverteiler 28 und einen Luftsammler 29 unterteilt.

Hierzu erstreckt sich das Luftleitblech 27 in der Weise von der Oberseite 30 des Baugruppenträgers 10 zum vorderen Rand 31 der Luftaustrittsöffnung 18, daß der Luftraum 25 diagonal unterteilt wird. Der oberseitige Fußpunkt 32 des Luftleitblechs 27 liegt etwa in einer Entfernung von der Frontseite 11, die der Tiefe des Aufnahmeraums 13 entspricht. Auf diese Weise umfaßt das Luftleitblech 27 sammlerseitig die gesamte horizontale Luftaustrittsöffnung 18 sowie eine vertikale Öffnung 33, die die gleiche Querschnittsfläche wie das Lüftungsgitter 26 hat und diesem gegenüberliegt. Verteilerseitig umfaßt das Luftleitblech 27 die dem Lüftungsgitter 26 zugeordnete frontseitige Luftansaugöffnung sowie eine oberseitige Gehäuseöffnung 34. Aus der Figur wird ersichtlich, daß sich die Gehäuseöffnung 34 mit der Lufteintrittsöffnung 16 des Baugruppenträgers 10 deckt. In Stapelanordnung decken sich somit auch die Gehäuseöffnung 34 des unteren Baugruppenträgers 10 und die bodenseitige Lufteintrittsöffnung 16′ des oberen Baugruppenträgers 100.

Der im unteren Baugruppenträger 10 angeordnete Luftsammler 29 dient somit zur Versorgung des Aufnahmeraums 13′ des darüber angeordneten Baugruppenträgers 100. Es dürfte deutlich sein, daß die Stapelung nicht nur auf die wiedergegebenen zwei Baugruppenträger 10,100 beschränkt ist, sondern daß eine beliebige Stapelhöhe möglich ist.

Die Öffnung 33 wird über einen zweiten Luftraum 35 mit einem Axiallüfter 36 beaufschlagt, der in der Rückwand 23 angeordnet ist. Im zweiten Luftraum 35, der nach unten durch den Zwischenboden 24, gegen den Aufnahmeraum 13 durch die Abdeckplatte 20 und nach oben durch eine an der Baugruppenoberseite 30 verlaufende Verlängerung 37 des Luftleitblechs 27 luftdicht abgeschlossen ist, kann sich beispielsweise ein Netzteil 38 zur Versorgung der Steckkarten 12 befinden. Anstelle des Axiallüfters kann auch jeder andere Lüftertyp eingesetzt werden. Wird mit Hilfe des Axiallüfters 36 ein Unterdruck erzeugt, so bewirkt dieser gemäß Pfeil 39 eine Luftansaugung in den Aufnahmeraum 13, wobei dies beim unteren Baugruppenträger 10 unmittelbar über die bodenseitige Lufteinstrittsöffnung 16 erfolgt. Die angesaugte Luft strömt über den Luftsammler 29 gemäß Pfeil 40 aus dem Aufnahmeraum 13 und wird über den Axiallüfter 36 gemäß Pfeil 41 an der Luftaustrittsoffnung ausgeblasen. Für den gestapelten, oberen Baugruppenträger 100 erfolgt beim Einschalten des zugehörigen Axiallüfters 36′ die Ansaugung von Kühlluft gemäß Pfeil 42 über den Luftsammler 29 des darunter angeordneten Baugruppenträgers 10. Von dort gelangt sie über die Lufteintrittsöffnung 16′ in den Aufnahmeraum 13′.

Wesentlich ist, daß durch die relativ große sammlerseitige Verbindungs öffnung 33 und die gleich große, mit dem Lüftungsgitter 26 versehene, verteilerseitig wirksame Luftansaugöffnung ein großer Volumenstrom erzeugt wird und dennoch der zum Verteilen und Sammeln erforderliche Luftraum 25 im Vergleich zum Aufnahmeraum 13 relativ klein gehalten werden kann. Die Luftführung ist dabei so gewählt, daß der größte Luftwiderstand erst im Bereich der Steckkarten 12 auftritt, was eine gleichmäßige Luftverteilung gewährleistet.

Wenn auch in dem dargestellten Beispiel der Luftverteiler/und -Sammler 28,29 oberhalb des Aufnahmeraums 13 angeordnet sind, so ist dennoch auch eine unterseitige Anordnung möglich. Hierzu ist lediglich eine sinngemäße Richtungsänderung des Luftleitblechs und eine Anpassung der Lüfteranordnung erforderlich.
Da der Luftwiderstand durch die erfindungsgemäße Luftführung minimiert wird, können Lüfter mit geringer Geräuschentwicklung verwendet werden. Wenn die Lüfteranordnung im oberen Teil des Baugruppenträgers - wie in der Figur dargestellt - angeordnet ist, ist über den unteren Raum 25 ein ungehinderter Zugang von hinten zur unteren Steckebene des Aufnahmeraums 13 möglich.

## Patentansprüche

(1) Baugruppenträger (10), inbesondere für Lüftungsanordnungen aus mindestens zwei gestapelten Baugruppenträgern,
(2) mit einem Aufnahmeraum (13) für vertikal angeordnete Leiterplatten, der eine Lufteintrittsöffnung (16, 16′) und eine gegenüberliegende, nahezu gleich große Luftaustrittsöffnung (18) aufweist und an den übrigen Seiten geschlossen ist,
(3) und mit einem Luftraum (25), der eine frontseitige Luftansaugöffnung (26) und ein diagonal verlaufendes Luftleitblech (27) aufweist, das den Luftraum (25) in einen Luftverteiler (28) und einen Luftsammler (29) teilt, die in der Tiefe des Raums nebeneinander liegen, wobei
(4) der Luftverteiler (28), der innerhalb eines Baugruppenträgers (10, 100), insbesondere oberhalb eines Aufnahmeraums (13, 13′) angeordnet ist, mit der frontseitigen Luftansaugöffnung (26) und einer weiteren Lufteintrittsöffnung (16′) eines weiteren Aufnahmeraums (13′) verbunden ist, während der Luftsammler (29) mit der Luftaustrittsöffnung (18) eines Aufnahmeraums (13) über eine der frontseitigen Luftansaugöffnung (26) gegenüberliegende, innenseitige Verbindungsöffnung (33) und einen zweiten Luftraum (35) mit einer Gebläseanordnung (36) in Verbindung steht, mit welcher ein Luftstrom durch den Luftverteiler (28), Aufnahmeraum (13, 13′), Luftsammler (29) und zweiten Luftraum (35) zu einer rückseitigen Luftaustrittsöffnung (41) geführt wird,
**dadurch gekennzeichnet**,
daß
(5) die Lufteintrittsöffnung (16, 16′) des Aufnahmeraums (13, 13′) unmittelbar in einem Gehäuseboden (14, 14′) des Baugruppenträgers (10, 100) und deckungsgleich zu einer Gehäuseöffnung (34) des Baugruppenträgers (10, 100) angeordnet ist, so daß sich bei Stapelanordnung der Baugruppenträger (10, 100) die oberseitige Gehäuseöffnung (34) eines unteren Baugruppenträgers (10) und die Lufteintrittsöffnung (16′) des Aufnahmeraums (13′) eines oberen Baugruppenträgers (100) decken, und
(6) daß der mit dem Luftsammler (29) verbundene zweite Luftraum (35) sich von der Oberseite (30) des Baugruppenträgers (10) bis zu einer Höhe unterhalb der Oberseite des Aufnahmeraums (13, 13′) und von einer rückseitigen Abdeckplatte (20) des Aufnahmeraumes (13, 13′) bis zu einer Rückwand (23) erstreckt, in welcher die Gebläseanordnung (36) und die Luftaustrittsöffnung (41) angeordnet sind.

2. Baugruppenträger nach Anspruch 1,
dadurch **gekennzeichnet**,
daß die Höhe des Luftraums (25) mit Luftverteiler (28) und Luftsammler (29) eine Höheneinheit gemäß dem 19-Zoll-System aufweist.

3. Baugruppenträger nach Anspruch 1 und 2,
dadurch **gekennzeichnet**,
daß sich der zweite Luftraum (35) über mehr als die halbe Höhe des Baugruppenträgers (10, 100), insbesondere über vier Höheneinheiten gemäß dem 19-Zoll-System erstreckt.

4. Baugruppenträger nach einem der vorhergehenden Ansprüche,
dadurch **gekennzeichnet**,
daß das Luftleitblech (27) zwischen einem vorderen Rand (31) der Luftaustrittsöffnung (18) bis zu einem Fußpunkt (32) an der Oberseite (30) des Baugruppenträgers (10) geführt ist, der etwa in einer Entfernung von der Frontseite (11) des Baugruppenträgers liegt, die der Tiefe des Aufnahmeraums (13) entspricht.

5. Baugruppenträger nach einem der vorhergehenden Ansprüche,
dadurch **gekennzeichnet**,
daß das Luftleitblech (27) an der Oberseite (30) des Baugruppenträgers (10) mit einer Verlängerung (37) bis zur Rückwand (23) des Baugruppenträgers (10, 100) versehen ist.

6. Baugruppenträger nach einem der vorhergehenden Ansprüche,
dadurch **gekennzeichnet**,
daß an der Unterseite (14) des Baugruppenträgers (10, 100) eine Abdeckung vorhanden ist, welche sich von der Rückwand (23) des Baugruppenträgers (10, 100) bis zur bodenseitigen Lufteintrittsöffnung (16) erstreckt.

## Claims

(1) A frame (10) particularly for ventilation systems comprising at least two stacked frames
(2) with a reception area (13) for vertically arranged circuit boards which has an air inlet (16, 16′) and an air outlet (18) of almost the same size located on the opposite side and which is closed on the other sides,
(3) with an air space (25) having a front air suction opening (26) and a diagonal cooling baffle (27) deviding the air space (25) in an air distributor (28) and an air collector (29), which are juxtaposed in the depth of the space, wherein
(4) the air distributor (28) which is positioned within a frame (10, 100), particularly above a reception area (13, 13′), is connected with the front air suction opening (26) and another air inlet (16′) of another reception area (13′), while the air collector (29)is connected with the air outlet (18) of a reception area (13) and via an inside connecting opening (33) located on the opposite side of the front air suction opening (26) and a second air space (35) with a blower system (36), which causes an air flow through the air distributor (28), reception area (13, 13′), air collector (29) and second air space (35) to an air outlet (41) located on the rear side,
**characterized** in that
(5) the air inlet (16, 16′) of the reception area (13, 13′) is arranged directly in the bottom of a casing (14, 14′) of the frame (10, 100) and is surface-corresponding to a casing opening (34) of the frame (10, 100), so that in a stacked assembly of the frames (10, 100) the top casing opening (34) of a bottom frame (10) corresponds to the air inlet (16′) of the reception area (13′) of a top frame (100), and
(6) that the second air space (35) which is connected to the air collector (29) extends from the top (30) of the frame (10) to a height below the top of the reception area (13, 13′) and from a rear cover plate (20) of the reception area (13, 13′) to a rear wall (23) in which the blower system (36) and the air outlet (41) are arranged.

2. A frame according to claim 1,
wherein the height of the air space (25) with air distributor (28) and air collector (29) is one height-unit according to the 19˝ system.

3. A frame according to claims 1 and 2,
wherein the second air space (35) extends over more than half the height of the frame (10, 100), particularly over four height-units according to the 19˝ system.

4. A frame according to one of the preceding claims,
wherein the cooling baffle (27) passes between a front edge (31) of the air outlet (18) to a base point (32) on the top (30) of the frame (10), wherein the base point (33) is roughly located in a distance from the front (11) of the frame corresponding to the depth of the reception area (13).

5. A frame according to one of the preceding claims,
wherein the cooling baffle (27) is provided on the top (30) of the frame (10) with an extension (37) to the rear wall (23) of the frame (10, 100).

6. A frame according to one of the preceding claims,
wherein on the under-side (14) of the frame (10, 100) is provided a cover extending from the rear wall (23) of the frame (10, 100) to the bottom air inlet (16).

## Revendications

(1) Support (10) de sous-ensembles pour dispositifs de ventilation, composé d'au moins deux supports de sous-ensembles
(2) comprenant une chambre de réception (13) pour des cartes de circuit imprimé disposées verticalement, qui présente une ouverture d'entrée d'air (16, 16′) et une ouverture de sortie d'air (18), placée en face, à peu près aussi grande, et qui est fermée sur les autres côtés,
(3) et comprenant une chambre à air (25) qui présente une ouverture d'aspiration d'air avant (26) et un déflecteur d'air oblique (27) qui divise la chambre à air (25) en un distributeur d'air (28) et un collecteur d'air (29), qui se trouvent l'un à côté de l'autre dans le sens de la profondeur de la chambre,
(4) le distributeur d'air (28), qui est disposé à l'intérieur d'un support de sous-ensembles (10,100)notamment au-dessus d'une chambre de réception (13, 13′), est relié à l'ouverture d'aspiration d'air avant (26) et à une autre ouverture d'entrée d'air (16′) appartenant à une autre chambre de réception (13′), cependant que le collecteur d'air (29) est en communication avec l'ouverture de sortie d'air (18) d'une chambre de réception (13) par l'intermédiaire d'une ouverture de communication interne (33) située en face de l'ouverture d'aspiration d'air avant (26), et par l'intermédiaire d'une deuxième chambre à air (35) munie d'un dispositif de ventilateur (36), avec lequel un courant d'air est transmis à une ouverture de sortie d'air arrière (41), à travers le distributeur d'air (28), la chambre de réception (13, 13′), le collecteur d'air (29) et la deuxième chambre à air (35),
***caractérisé en ce que***
(5) l'ouverture d'entrée d'air (16, 16′) de la chambre de réception (13, 13′) est disposée directement dans un fond de boîtier (14, 14′) du support de sous-ensembles (10, 100) et en superposition par rapport à une ouverture de boîtier (34) du support de sous-ensembles (10, 100) de telle manière que, lorsque les supports de sous-ensembles (10, 100) sont empilés, l'ouverture supérieure de boîtier (34) d'un support de sous-ensembles inférieur (10) et l'ouverture d'entrée d'air (16′) de la chambre de réception (13′) d'un support de sous-ensembles supérieur (100) se recouvrent mutuellement, et
(6) en ce que la deuxième chambre à air (35) qui est reliée au collecteur d'air (29) s'étend de la face supérieure (30) du support de sous-ensembles (10) jusqu'à une hauteur située au-dessous de la face supérieure de la chambre de réception (13, 13′), et d'une plaque de fermeture arrière (20) de la chambre de réception (13, 13′) jusqu'à une paroi arrière (23) dans laquelle sont disposés le dispositif de ventilateur (36) et l'ouverture de sortie d'air (41).

2. Support de sous-ensembles selon la Revendication 1, ***caractérisé en ce que*** la hauteur de la chambre à air (25) comprenant le distributeur d'air (28) et le collecteur d'air (29) possède une unité de hauteur du système 19 pouces.

3. Support de sous-ensembles selon la Revendication 1 ou 2, ***caractérisé en ce que*** la deuxième chambre à air (35) s'étend sur plus de la moitié de la hauteur du support de sous-ensembles (10, 100), notamment sur quatre unités de hauteur du système 19 pouces.

4. Support de sous-ensembles selon- une des Revendications précédentes, ***caractérisé en ce que*** le déflecteur d'air (27) s'étend depuis un bord avant (31) de l'ouverture de sortie d'air (18) jusqu'à un point de pied (32) au niveau de la face supérieure (30) du support de sous-ensembles (10), qui est situé environ à une distance de la face avant (11) du support de sous-ensembles qui correspond à la profondeur de la chambre de réception (13).

5. Support de sous-ensembles selon une des Revendications précédentes, ***caractérisé en ce qu***'au niveau de la face supérieure (30) du support de sous-ensembles (10), le déflecteur (27) est muni d'un prolongement (37) s'étendant jusqu'à la paroi arrière (23) du support de sous-ensembles (10, 100).

6. Support de sous-ensembles selon une des Revendications précédentes, ***caractérisé en ce qu***'au niveau de la face inférieure (14) du support de sous-ensembles (10, 100) est placé un recouvrement qui s'étend de la paroi arrière (23) du support de sous-ensembles (10, 100) jusqu'à l'ouverture d'entrée d'air (16) du côté du fond.
